# DEMANDE DE BREVET EUROPEEN

(11) **EP 1 347 467 A1**
(43) Date de publication de la demande: **24.09.2003**
(21) Numéro de dépôt: 02405215.1
(22) Date de dépôt: 21.03.2002
(51) Int. Cl.: H01B 12/10, H01L 39/14, B21C 23/08

(54) **Gaine pour câble supraconducteur multifilament et son procédé de fabrication**

(71) Demandeur: Metalor Technologies SA, 2009 Neuchâtel (CH)
(72) Inventeur: Hauner, Franz, 91341 Röttenbach (DE); Robertson Ferrier, William Andrew, Tenbury Wells, Worcestershire WR15 8JJ (GB)
(74) Mandataire: Gresset, Jean

(57) **Abrégé**

L'invention concerne un gaine pour câble supraconducteur multifilament à haute température, caractérisée en ce qu'elle est constituée d'un tube (10) dont la paroi multicouche comporte :
- une couche intérieure (12, 16, 22) d'argent pur, et
- au moins une deuxième couche (14, 18, 24, 26) d'alliage à base d'argent.

L'invention concerne également un procédé de fabrication d'une telle gaine. Il est caractérisé en ce que le tube à paroi multicouche (10) est obtenu par co-extrusion d'une billette cylindrique formée d'au moins deux cylindres concentriques.

## Description

La présente invention se rapporte aux câbles et bandes supraconducteurs utilisés à la température de l'azote liquide (-196°C) et dits "à haute température" afin de les distinguer de ceux qui fonctionnent à des températures proches de -273°C.

Afin de faciliter la lecture de ce document, il est entendu que le mot «câble» sera utilisé pour désigner, à la fois, des câbles proprement dits et des bandes formées par écrasement de ces câbles.

L'invention concerne, plus particulièrement, d'une part, une gaine servant de matrice pour les fibres supraconductrices à haute température d'un câble multifilament et, d'autre part, un procédé de fabrication d'une telle gaine.

Les câbles supraconducteurs du type ci-dessus sont généralement constitués d'un faisceau de fils en matériau supraconducteur disposés à l'intérieur d'une matrice qui les isole les uns des autres et de l'extérieur.

Le matériau supraconducteur est, typiquement, un oxyde tel que ceux dénommés BSCCO 2223 et 2212 et dont d'autres exemples sont fournis, notamment, dans le brevet US 6 188 921.

Plus précisément, chaque fil supraconducteur est contenu dans une gaine de matériau compatible amenée par étirage à sa dimension finale, d'environ 1,5 mm. Ce fil est ensuite réuni en faisceau avec d'autres fils identiques à l'intérieur d'une gaine externe qui est, à son tour, étirée jusqu'à un diamètre d'environ 1.5 mm, pour former un câble ou, après laminage, une bande multifilament.

La matrice que forment les gaines est généralement métallique. L'argent et ses alliages constituent un matériau préféré des spécialistes dans le domaine car il est ductile, ne pollue pas le fil supraconducteur et est relativement transparent à l'oxygène.

Malheureusement, l'argent présente des inconvénients. En effet, lorsqu'il est pur, ses propriétés, d'une part, ne lui permettent pas de renforcer le supraconducteur contre de fortes contraintes électromagnétiques dans des champs importants et, d'autre part, ne mettent pas le fil à l'abri d'une rupture. De plus, sa conductivité électrique élevée favorise des pertes ohmiques importantes pour les applications en courant alternatif (pertes transversales).

Pour pallier la faiblesse mécanique de l'argent, il est courant d'utiliser des alliages plus robustes, notamment l'alliage AgMgNi qui durcit par oxydation interne, bien connu dans le domaine. Mais cet alliage n'est, à son tour, pas exempt d'inconvénient. En effet, le nickel qu'il contient est un poison pour le matériau supraconducteur et le magnésium oxydé empêche le soudage entre les fibres lors de la fabrication des multifilaments.

Pour pallier la haute conductivité électrique de l'argent, on utilise des alliages résistifs, notamment l'alliage AgAu qui, lui non plus, n'est pas sans inconvénient. Dans certaines conditions, en effet, l'or affecte les propriétés du supraconducteur.

La présente invention a pour but de fournir une technologie exempte des inconvénients susmentionnés, tout en bénéficiant des avantages offerts par les procédés de l'art antérieur.

De façon plus précise, l'invention concerne une gaine pour câble supraconducteur à haute température, caractérisée en ce qu'elle est constituée d'un tube dont la paroi multicouche comporte :
- une couche intérieure d'argent pur, et
- au moins une deuxième couche d'alliage à base d'argent.

La paroi peut être réalisée en deux, trois ou quatre couches.

De manière avantageuse, les alliages à base d'argent utilisés sont un alliage à forte résistance mécanique, un alliage à forte résistance électrique ou un alliage à forte résistance mécanique et forte résistance électrique.

L'invention concerne également un procédé de fabrication d'une gaine telle que définie ci-dessus. Il est caractérisé en ce que le tube à paroi multicouche est obtenu par co-extrusion d'une billette cylindrique formée d'au moins deux cylindres concentriques.

D'autres caractéristiques de l'invention ressortiront de la description qui va suivre, faite en regard du dessin annexé, dans lequel :
- les figures 1, 1a, 1b et 1c représentent un tube pour gaine interne,
- les figures 2, 2a, 2b et 1c représentent un tube pour gaine externe, et
- la figure 3 montre la billette utilisée pour l'obtention de ces tubes.

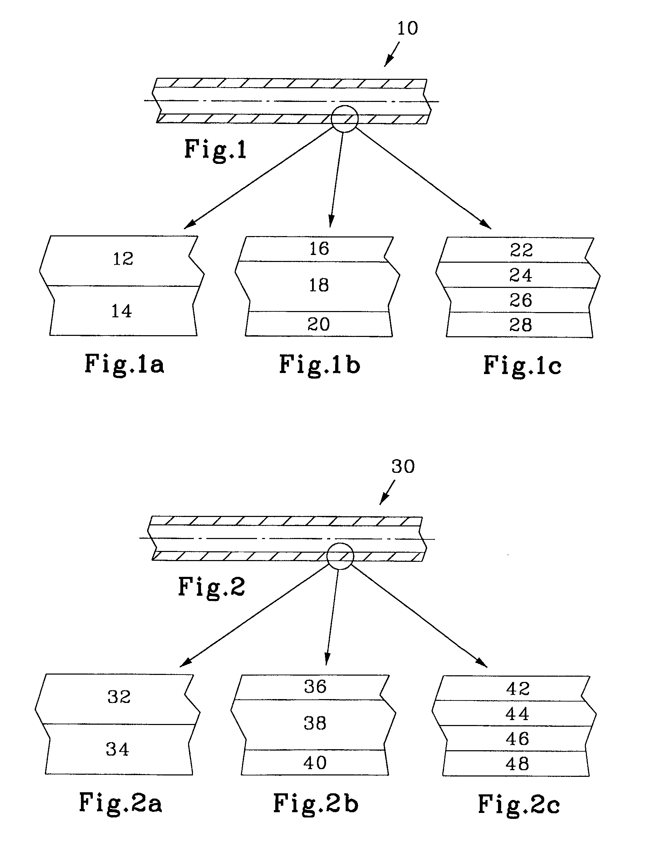

Sur la figure 1, on a représenté en 10 un tube destiné à former la gaine d'un fil supraconducteur, dite gaine interne. Typiquement, ce tube a un diamètre extérieur de 20 mm et un diamètre intérieur de 17 mm. Sa longueur peut aller de 1 à 3 m. Un tel tube, une fois rempli de matériau supraconducteur, est destiné à être étiré jusqu'à un diamètre d'environ 1.5 mm. Il sera ensuite réuni en faisceau avec d'autres fils identiques à l'intérieur d'une gaine externe pour former un faisceau supraconducteur qui sera, à son tour, étiré jusqu'à un diamètre d'environ 1.5 mm, pour former un câble ou, après laminage, une bande multifilament. Le processus de gainage multiple peut éventuellement être effectué en plusieurs étapes faisant appel à au moins une gaine intermédiaire. Dans ce cas, la structure de la gaine intermédiaire est la même que celle de la gaine interne.

Selon l'invention, la paroi du tube 10 peut être formée de deux, trois ou quatre couches à base d'argent, comme représenté à échelle agrandie sur les figures 1a, 1b et 1c respectivement.

Quatre matériaux différents sont utilisés pour la constitution des couches, à savoir :
- de l'argent pur ;
- de l'argent à forte résistance mécanique, dit argent dur, qui peut être, par exemple, l'un des alliages suivants : AgMgNi (99.55 - 0.25 - 0.20), AgMn (99 - 1);
- de l'argent à forte résistance électrique, dit argent résistif, qui peut être, par exemple, l'un des alliages suivants : AgAu (96 - 4), AgSb (99-1); et
- de l'argent à forte résistance mécanique et électrique, dit argent dur-résistif, qui peut être, par exemple, AgAuMgNi (95.55 - 4 - 0.25-0.20).

Selon le mode de réalisation à deux couches de la figure 1a, la couche intérieure 12 est de l'argent pur et la couche extérieure 14 de l'argent résistif.

Selon le mode de réalisation à trois couches de la figure 1b, la couche intérieure 16 est de l'argent pur, la couche intermédiaire 18 de l'argent dur ou de l'argent dur-résistif et la couche extérieure 20 de l'argent pur. En variante, la couche intérieure 16 est de l'argent pur, la couche intermédiaire 18 de l'argent dur et la couche extérieure 20 de l'argent résistif.

Enfin, selon le mode de réalisation à quatre couches de la figure 1c, la couche intérieure 22 est de l'argent pur, la première couche intermédiaire 24 de l'argent dur, la deuxième couche intermédiaire 26 de l'argent résistif et la couche extérieure 28 de l'argent pur. En variante, la première couche intermédiaire 24 est de l'argent résistif et la deuxième couche intermédiaire 26 de l'argent dur.

On se référera maintenant à la figure 2 qui représente en 30 un tube destiné à former la gaine externe d'un câble supraconducteur, mentionnée précédemment. Par ses dimensions, le tube 30 ne se distingue pas du tube 10 non étiré qui vient d'être décrit. Comme lui, sa paroi peut être formée de deux, trois ou quatre couches à base d'argent, ainsi que représenté à échelle agrandie sur les figures 2a, 2b et 2c respectivement. Les matériaux constitutifs sont les mêmes, mais l'organisation des différentes couches est différente.

Selon le mode de réalisation à deux couches de la figure 2a, la couche intérieure 32 est de l'argent pur et la couche extérieure 34 de l'argent dur ou de l'argent dur-résistif.

Selon le mode de réalisation à trois couches de la figure 2b, la couche intérieure 36 est de l'argent pur, la couche intermédiaire 38 de l'argent dur ou de l'argent dur-résisitif et la couche extérieure 40 de l'argent. Dans une première variante, la couche intérieure 36 est de l'argent pur, la couche intermédiaire 38 de l'argent dur et la couche extérieure 40 de l'argent résistif. Dans une deuxième variante, la couche intérieure 36 est de l'argent pur, la couche intermédiaire 38 de l'argent résistif et la couche extérieure 40 de l'argent dur.

Enfin, selon le mode de réalisation à quatre couches de la figure 2c, la couche intérieure 42 est de l'argent pur, la première couche intermédiaire 44 de l'argent dur, la deuxième couche intermédiaire 46 de l'argent résistif et la couche extérieure 48 de l'argent pur. En variante, la première couche intermédiaire 44 est de l'argent résistif et la deuxième couche intermédiaire 46 de l'argent dur.

Qu'il s'agisse des tubes pour gaine interne ou pour gaine externe, les proportions relatives en volume des différentes couches sont les suivantes :
- structure à deux couches :
   . couche intérieure : 10 à 90%
   . couche extérieure : 90 à 10%
- structure à trois couches :
   . couches intérieure et extérieure : 10 à 40%
   . couche intermédiaire : 80 à 20%
- structure à quatre couches :
   . couches intérieure et extérieure : 10 à 40%
   . couches intermédiaires : 70 à 10%

Ainsi sont réalisés un tube pour gaine interne ou intermédiaire et un tube pour gaine externe qui, grâce, à leur structure multicouche, permettent de bénéficier des qualités de l'argent pur et de différents de ses alliages (plus durs et plus résistifs) tout en masquant leurs effets indésirables. Ces gaines permettent de réaliser des bandes supraconductrices d'excellente qualité.

On notera, en particulier, que la structure proposée permet, notamment grâce à la présence d'une couche d'alliage d'argent à forte résistivité, de réduire sensiblement les pertes ohmiques dans les applications en courant alternatif. Par ailleurs, pour les tubes utilisant un alliage durci par oxydation, comme AgMgNi, AgAuMgNi ou AgMn, un gainage extérieur par un métal non oxydable, comme Ag pur ou AgAu, permet d'éviter l'oxydation du Mg ou du Mn durant les première phases de fabrication en le protégeant de l'atmosphère ambiante et de limiter fortement l'usure des filières utilisées.

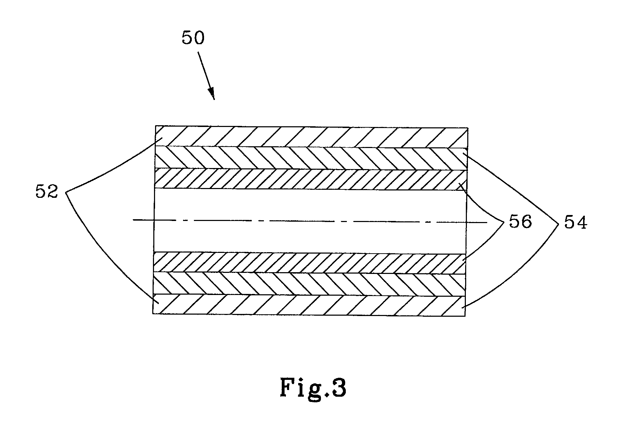

Le tubes multicouche selon l'invention sont avantageusement obtenus par co-extrusion d'une billette cylindrique 50, telle que montrée à la figure 3 dans le cas d'une structure à trois couches, formée alors de trois cylindres concentriques 52, 54 et 56. Typiquement, cette billette a un diamètre extérieur d'environ 120 mm.

La billette 50 peut être préparée soit en assemblant trois tubes métalliques, de diamètres externe et interne appropriés, respectivement constitués des matériaux désirés, soit en formant, à l'intérieur d'un container, par pressage isostatique à froid, trois tubes en poudre de ces matériaux, puis en soumettant le tout à une opération de frittage, typiquement à une température de 850°C.

Pour simplifier la réalisation de l'assemblage, le tube interne peut éventuellement être remplacé par un cylindre plein, lequel est percé par la suite.

L'extrusion de la billette 50 est effectuée ensuite selon tout procédé connu de l'homme de métier pour obtenir finalement le tube 10 ou 30, dont le diamètre extérieur est réduit d'un facteur 2 à 10 par rapport au diamètre initial de la billette.

## Revendications

1. Gaine pour câble supraconducteur multifilament à haute température, **caractérisée en ce qu'**elle est constituée d'un tube (10, 30) dont la paroi multicouche comporte :
- une couche intérieure d'argent pur, et
- au moins une deuxième couche d'alliage à base d'argent.

2. Gaine interne pour câble supraconducteur multifilament selon la revendication 1, **caractérisée en ce que** la paroi du tube est formée de deux couches, soit :
- une couche intérieure (12) d'argent pur, et
- une couche extérieure (14) d'alliage d'argent à forte résistance électrique.

3. Gaine interne pour câble supraconducteur multifilament selon la revendication 1, **caractérisée en ce que** la paroi du tube est formée de trois couches, soit :
- une couche intérieure (16) d'argent pur,
- une couche intermédiaire (18) d'alliage d'argent à forte résistance mécanique, et
- une couche extérieure (20) d'argent pur.

4. Gaine interne pour câble supraconducteur multifilament selon la revendication 1, **caractérisée en ce que** la paroi du tube est formée de trois couches, soit :
- une couche intérieure (16) d'argent pur,
- une couche intermédiaire (18) d'alliage argent à forte résistance mécanique et forte résistance électrique, et
- une couche extérieure (20) d'argent pur.

5. Gaine interne câble supraconducteur multifilament selon la revendication 1, **caractérisée en ce que** la paroi du tube est formée de trois couches, soit :
- une couche intérieure (16) d'argent pur,
- une couche intermédiaire (18) d'alliage argent à forte résistance mécanique, et
- une couche extérieure (20) d'argent à forte résistance électrique.

6. Gaine interne pour câble supraconducteur multifilament selon la revendication 1, **caractérisée en ce que** la paroi du tube est formée de quatre couches, soit :
- une couche intérieure (22) d'argent pur,
- une première couche intermédiaire (24) d'alliage d'argent à forte résistance mécanique,
- une deuxième couche intermédiaire (26) d'alliage d'argent à forte résistance électrique, et
- une couche extérieure (28) d'argent pur.

7. Gaine interne pour câble supraconducteur multifilament selon la revendication 1, **caractérisée en ce que** la paroi du tube est formée de quatre couches, soit :
- une couche intérieure (22) d'argent pur,
- une première couche intermédiaire (24) d'alliage argent à forte résistance électrique,
- une deuxième couche intermédiaire (26) d'alliage argent à forte résistance mécanique, et
- une couche extérieure (28) d'argent pur.

8. Gaine externe pour câble supraconducteur multifilament selon la revendication 1, **caractérisée en ce que** la paroi du tube est formée de deux couches, soit :
- une couche intérieure (32) d'argent pur, et
- une couche extérieure (34) d'alliage d'argent à forte résistance mécanique.

9. Gaine externe pour câble supraconducteur multifilament selon la revendication 1, **caractérisée en ce que** la paroi du tube est formée de deux couches, soit :
- une couche intérieure (32) d'argent pur, et
- une couche extérieure (34) d'alliage d'argent à forte résistance mécanique et forte résistance électrique.

10. Gaine externe pour câble supraconducteur multifilament selon la revendication 1, **caractérisée en ce que** la paroi du tube est formée de trois couches, soit :
- une couche intérieure (36) d'argent pur,
- une couche intermédiaire (38) d'alliage d'argent à forte résistance mécanique, et
- une couche extérieure (40) d'argent pur.

11. Gaine externe pour câble supraconducteur multifilament selon la revendication 1, **caractérisée en ce que** la paroi du tube est formée de trois couches, soit :
- une couche intérieure (36) d'argent pur,
- une couche intermédiaire (38) d'alliage d'argent à forte résistance mécanique et forte résistance électrique, et
- une couche extérieure (40) d'argent pur.

12. Gaine externe pour câble supraconducteur multifilament selon la revendication 1, **caractérisée en ce que** la paroi du tube est formée de trois couches, soit :
- une couche intérieure (36) d'argent pur,
- une couche intermédiaire (38) d'alliage d'argent à forte résistance mécanique, et
- une couche extérieure (40) d'alliage d'argent à forte résistance électrique.

13. Gaine externe pour câble supraconducteur multifilament selon la revendication 1, **caractérisée en ce que** la paroi du tube est formée de trois couches, soit :
- une couche intérieure (36) d'argent pur,
- une couche intermédiaire (38) d'alliage d'argent à forte résistance électrique, et
- une couche extérieure (40) d'alliage d'argent à forte résistance mécanique.

14. Gaine externe pour câble supraconducteur multifilament selon la revendication 1, **caractérisée en ce que** la paroi du tube est formée de quatre couches, soit :
- une couche intérieure (42) d'argent pur,
- une première couche intermédiaire (44) d'alliage d'argent à forte résistance mécanique,
- une deuxième couche intermédiaire (46) d'alliage d'argent à forte résistance électrique, et
- une couche extérieure (48) d'argent pur.

15. Gaine externe pour câble supraconducteur multifilament selon la revendication 1, **caractérisée en ce que** la paroi du tube est formée de quatre couches, soit :
- une couche intérieure (42) d'argent pur,
- une première couche intermédiaire (44) d'alliage argent à forte résistance électrique,
- une deuxième couche intermédiaire (46) d'alliage d'argent à forte résistance mécanique, et
- une couche extérieure (48) d'argent pur.

16. Procédé de fabrication d'une gaine pour un câble supraconducteur multifilament selon l'une des revendications 1 à 15, **caractérisé en ce que** ledit tube à paroi multicouche est obtenu par co-extrusion d'une billette cylindrique (50) formée d'au moins deux cylindres concentriques (52, 54, 56).

17. Procédé selon la revendication 16, **caractérisé en ce que** ladite billette (50) est réalisée en assemblant au moins deux tubes métalliques respectivement constitués des matériaux désirés.

18. Procédé selon la revendication 16, **caractérisé en ce que** ladite billette (50) est réalisée en formant, à l'intérieur d'un container, par pressage isostatique à froid, au moins deux tubes en poudre respectivement constitués des matériaux désirés, puis en soumettant ces tubes à une opération de frittage.
